Europäisches Patentamt

European Patent Office

Office européen des brevets

(19)

(11) Veröffentlichungsnummer: **0 340 343 B1**

(12) **EUROPÄISCHE PATENTSCHRIFT**

(45) Veröffentlichungstag der Patentschrift: **12.08.92**

(21) Anmeldenummer: **88121384.7**

(22) Anmeldetag: **21.12.88**

Teilanmeldung 91119416.5 eingereicht am 21/12/88.

(51) Int. Cl.5: **H03M 1/30**, G06K 11/06, G08C 19/16

(54) Drahtloses Fernsteuersystem elektronischer Geräte.

(30) Priorität: **30.04.88 EP 88106983**

(43) Veröffentlichungstag der Anmeldung:
**08.11.89 Patentblatt 89/45**

(45) Bekanntmachung des Hinweises auf die Patenterteilung:
**12.08.92 Patentblatt 92/33**

(84) Benannte Vertragsstaaten:
**DE FR GB IT NL**

(56) Entgegenhaltungen:
**EP-A- 0 206 246**
**EP-A- 0 209 411**
**GB-A- 1 203 597**
**US-A- 2 948 890**
**US-A- 3 996 463**

(73) Patentinhaber: **Deutsche ITT Industries GmbH**
**Hans-Bunte-Strasse 19 Postfach 840**
**W-7800 Freiburg i.Br.(DE)**

(72) Erfinder: **Heberle, Klaus, Dipl.-Ing. (FH)**
**Hinter den Eichen 42**
**W-7801 Reute(DE)**

EP 0 340 343 B1

Rank Xerox (UK) Business Services

# Beschreibung

Übliche Fernsteuergeber von drahtlosen Fernsteuersystemen elektronischer Geräte, insbesondere solcher der Unterhaltungselektronik, erzeugen in Abhängigkeit von vom Benutzer zu betätigenden Tasten Steuersignale für das bzw. die zu steuernden Geräte. Dabei dient als Übertragungsmedium ein entsprechend moduliertes Ultraschall- bzw. Infrarotsignal.

Im Hinblick auf die Vielzahl der heute möglichen und damit auch erforderlichen Steuerbefehle erscheint es nicht mehr tragbar, die Anzahl der Tasten des Fernsteuergebers weiter zu erhöhen, sondern sie ist gerade drastisch zu verringern, ohne dabei jedoch die Steuermöglichkeiten zu reduzieren.

Aus EP-A 0 209 411 ist ein Steuersystem für ein elektronisches Gerät bekannt, das einem Piloten mittels einer Kopfbewegung ermöglicht, ein Steuersignal auszulösen. Dabei werden dem Piloten mittels eines Bildschirms eine Vielzahl von Steuerbefehlen zur Auswahl angeboten. Jeder Steuerbefehl ist einem auf dem Bildschirm dargestellten kleinen Feld zugeordnet und der Pilot wählt daraus den gewünschten Steuerbefehl aus. Dieses Verfahren ist bei der Bedienung von Computern unter dem Namen "Menü-Steuerung" bekannt. Statt der üblichen Menü-Auswahl beim Computer mittels einer manuell bewegten "Maus" erfolgt in der Anordnung nach EP-A 0 209 411 die Menü-Auswahl durch die Kopfbewegung des Piloten. Hierzu wird die relative Position zwischen dem Helm des Piloten und einem festen Bezugspunkt mittels eines elektrooptischen Systems bestimmt. Dieses besteht im wesentlichen auf der Fernbedienungsempfängerseite aus einer optischen Strahlungsquelle, die räumlich fest angeordnet ist, und auf der Fernbedienungsgeberseite aus einem optischen Vierquadranten-Strahlungsdetektor, der fest mit dem Pilotenhelm verbunden auf die Strahlungsquelle ausgerichtet ist. Mit der Kopfbewegung ändert sich die Lage der abgebildeten Strahlungsquelle auf dem mitbewegten Strahlungsdetektor - der Leuchtfleck bewirkt dabei eine andere Lichtverteilung auf dem Vierquadranten-Strahlungsdetektor. Seine elektrischen Ausgangssignale werden über Draht einer teilweise analog, teilweise digital arbeitenden Rechenschaltung zugeführt, die mit der Ablenkeinheit und Strahlsteuerung des Bildschirmes gekoppelt ist und dort dasjenige Feld hervorhebt, das der jeweiligen Helmausrichtung zugeordnet ist.

Aus GB-A 1 203 597 ist ein Gerät bekannt, das eine x-y-Koordinateneinstellung über jeweils eine Linienrasterplatte in x- und y-Richtung steuert, wobei die jeweilige Anzahl der durchlaufenen Linien optisch abgetastet und elektronisch gezählt wird.

Aus EP-A 0 206 246 ist eine optisch gesteuerte "Maus" zur Computersteuerung bekannt, die über diagonal liegende photoempfindliche Sensoren das Gitterraster eines "Tabletts" abtastet und auswertet und die elektrischen Signale einer Auswertungsschaltung zuführt. Zur Steuerung wird die Maus manuell auf dem Tablett in beliebiger Richtung bewegt.

Aus US-A 3 996 463 ist ein Gerät bekannt, das mittels des Fraunhoferschen Diffraktionseffekts die relative Position zwischen einem Lichtstrahl und einem optischen Gitter auswertet. Dies ermöglicht eine genaue Positionsbestimmung bei sehr kleinen Relativbewegungen.

Aus US-A 2 948 890 ist eine weitere Anordnung bekannt, die an einem Gerät eine relative Positionsbestimmung in einer Richtung mittels elektrooptischer Mittel ermöglicht. Diese Anordnung verwendet eine Maske mit streifenförmigen Öffnungen und einen dahinterliegenden Reflektor mit streifenförmigen Reflexionszonen. Die Relativbewegung zwischen der Streifenmaske und dem dahinterliegenden Reflektor erzeugt ein Hell-Dunkel-Signal, dessen Wechsel zur Positionsbestimmung elektronisch ausgewertet wird. Dies erfolgt beispielsweise durch einfache Zählung der Helligkeitsimpulse. Der jeweilige Richtungssinn der Bewegung wird durch eine parallele zweite Streifenmaske ermittelt, die gegenüber der ersten etwas versetzt ist und entsprechend ein zeitlich versetztes Helligkeitssignal erzeugt.

Es ist Aufgabe der in den Ansprüchen gekennzeichneten Erfindung ein drahtloses Fernsteuersystem für elektronische Geräte, insbesondere der Unterhaltungselektronik, anzugeben, das besonders einfach aufgebaut ist und ohne eine räumlich feste Strahlungsquelle auskommt.

Die Erfindung wird nun anhand der Figuren der Zeichnung näher erläutert:

Fig. 1 zeigt stark schematisiert die im Fernsteuergeber angeordneten elektrooptischen Bauteile gemäß der Erfindung,

Fig. 2 zeigt stark schematisiert die Anordnung der Strahlungsdetektoren im Fernbedienungsempfänger gemäß der Erfindung,

Fig. 3 zeigt schematisch als Blockschaltbild eine Schaltungsanordnung zur Trennung der getakteten horizontalen und vertikalen Detektor-Ausgangssignale und

Fig. 4 zeigt schematisch den Zeitablauf einiger Signale der Fig. 3.

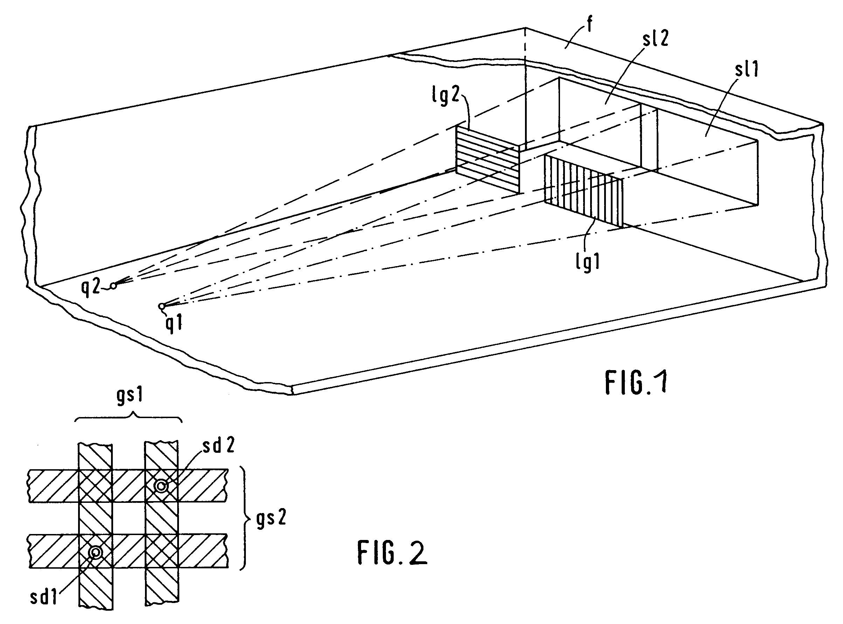

In Fig. 1 ist das der Erfindung zugrundeliegende Prinzip schematisch gezeigt, und zwar anhand der perspektivischen Schnittdarstellung des Fernsteuergebers f. Dabei sind jedoch nur diejenigen Teile gezeigt, die die elektrooptische Ausgangsstufe betreffen. Hierzu ist innerhalb des Fernsteuergebers f vor der jeweiligen Strahlenöffnung sl1, sl2 das jeweilige Liniengitter lg1, lg2 angeordnet, das jeweils von der Strahlungsquelle q1, q2, vorzugsweise wiederrum eine Infrarotquelle, bestrahlt wird, wie es durch die zugleich als Perspektivlinien dienenden Strahlen durch die vier Ecken der Liniengitter lg1, lg2 und der Strahlenöffnungen sl1, sl2 angedeutet ist.

Das Liniengitter lg1 hat vertikale äquidistante Linien, das Liniengitter lg2 dagegen horizontale äquidistante Linien, so daß die beiden Linienscharen um 90° gegeneinander versetzt sind. Damit die z.B. von der Strahlungsquelle q1 ausgehende Strahlung nur das zugehörige Liniengitter lg1 beaufschlagt, sind die Strahlungsquellen q1, q2 durch eine aus zeichnungstechnischen Gründen nicht darstellbare Trennwand voneinander abgeschirmt, die längs durch die elektronische Ausgangsstufe bis zum Steg zwischen den beiden Öffnungen sl1, sl2 verläuft.

Innerhalb des nichtgezeigten Teils des Fernsteuergebers f sind dessen übliche Schaltungsteile angeordnet. Es sind dies hier im wesentlichen die Schaltungsteile zur Erzeugung der einzelnen Fernsteuersignale und zur Ansteuerung der beiden Strahlungsquellen q1, q2.

In Fig. 2 ist stark schematisiert gezeigt, wie am Fernbedienungsempfänger, also in der Regel am elektronischen Gerät g, die Strahlungsdetektoren sd1, sd2 angeordnet sind, nämlich so, daß ihre Verbindungslinie mit der Richtung der vertikalen und horizontalen Schatten gs1, gs2 der Liniengitter lg1, lg2 jeweils einen Winkel von 45° bildet. Dies hat den Vorteil, daß die Bewegungserkennung in vertikaler und horizontaler Richtung mit nur zwei Strahlungsdetektoren ermöglicht wird.

Mittels der Information über die Bewegungsweite des Fernsteuergebers f läßt sich ein analoges bzw. kontinuierliches Steuersignal, wie z.B. für die Lautstärke oder für die Helligkeit oder den Kontrast, erzeugen. Es sind jedoch auch sogenannte Menü-Steuerungen möglich, wie sie von Computern und der bekannten sogenannten Maus her bekannt und üblich sind. Der Fernsteuergeber kann somit nach der Erfindung als "elektronische Maus" ausgebildet werden.

Sehr einfach ist die horizontale und die vertikale Bewegungserkennung bei dem Ausführungsbeispiel nach den Figuren 1 und 2, weil ein einziges diagonal ausgerichtetes Strahlungsdetektorpaar die Bewegungsrichtungen trennen kann. Dabei ist allerdings eine Kennung erforderlich, die erkennen läßt, ob das horizontale oder das vertikale Liniengitter lg2, lg1 gerade projiziert wird. Als Kennungsmittel eigenen sich z.B. unterschiedliche Impulslängen, Impulspausen, Impulsfolgen oder Synchronisierzeichen wie Mehrfachimpulse und dergleichen mehr.

Die Ansteuerung der beiden Strahlungsquellen q1, q2 erfolgt dabei bevorzugt im Zeitmultiplexbetrieb mit kurzen Ansteuerimpulsen und einer Taktfrequenz, die hoch im Vergleich zum niederfrequenten Informationsgehalt der beiden Detektorsignale ist und sich daher wieder leicht herausfiltern läßt.

Die beiden Strahlungsquellen q1, q2 werden zur Kennung bevorzugt z.B. derart getaktet angesteuert, daß die Ansteuerpause zwischen der Ansteuerung der Strahlungsquelle q1 und der der Strahlungsquelle q2 kürzer (oder länger) ist als die Ansteuerpause zwischen der Ansteuerung der Strahlungsquelle q2 und der der Strahlungsquelle q1. Bei der Ansteuerreihenfolge q1, q2, ... kann die Ansteuerpausenfolge z.B. sein: 1 Mikrosekunde, 2 Mikrosekunden, 1 Mikrosekunde, .... Die Taktung ist also eine abwechselnde Ansteuerung der Strahlungsquellen q1, q2 und die unterschiedlich lange Pausen sind die Kennung.

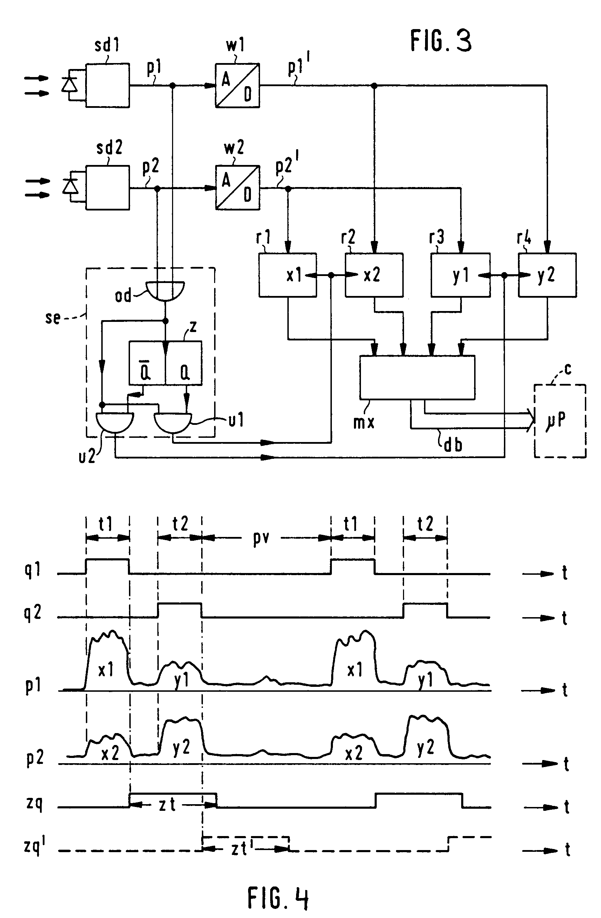

Die Fig. 3 zeigt schematisch als Blockschaltbild eine Schaltungsanordnung zur Trennung der vertikalen und horizontalen Signalkomponenten dieser beiden diagonal angeordneten Strahlungsdetektoren sd1, sd2. Bei dieser Schaltungsanordnung wird dabei als weiterer Vorteil nicht von einem festen Schwellwert ausgegangen, wie er beispielsweise erforderlich wäre, wenn mittels fester Trigger-Schaltungen aus den beiden Strahlungsdetektor-Ausgangssignalen, Rechteckimpulse für die weitere Verarbeitung gebildet würden. Denn mit einem festen Schwellenwert wäre das entfernungsabhängige, stark in der Amplitude schwankende Ausgangssignal der Strahlungsdetektoren sd1, sd2 nur in einem kleinen Amplitudenbereich optimal erfaßbar. Bei großen Amplituden infolge kurzer Entfernung wäre der Schwellwert zu tief und im anderen Fall, bei kleinen Amplituden infolge großer Entfernung, wäre der Schwellwert zu hoch. Abhilfe schafft hier, daß die Detektor-Ausgangssignale p1, p2 mittels der beiden Analog-Digitalumsetzer w1, w2 digitalisiert werden und als digitale Signale p1', p2' einer rein digitalen Auswertung, z.B. mittels des schematisch dargestellten Mikroprozessors c, zugeführt werden.

Die digitale Verarbeitung erlaubt den relativen Amplitudenvergleich der digitalen Signale p1', p2' oder bildet aus deren Amplitudenwerten einen mitlaufenden Schwellwert, wobei z.B. in Software ausgebildete Filterschaltungen ferner der Störsignalunterdrückung dienen können.

Bei der in Fig. 3 dargestellten Trennschaltung ist das Ausgangssignal des ersten Strahlungsdetektors sd1, nämlich daß Detektor-Ausgangssignal p1 auf den Eingang des ersten Analog-Digitalumsetzers w1 und auf den einen Eingang des ersten ODER-Gatters od geführt. Das Ausgangssignal des zweiten Strahlungsdetektors sd2 ist entsprechend auf den zweiten Analog-Digitalumsetzer w2 und auf den anderen Eingang des ODER-Gatters od geführt.

Dieses ist Teil der Steuereinrichtung se, die entscheidet, ob die Detektor-Ausgangssignale p1, p2 dem horizontalen oder dem vertikalen Liniengitter lg2, lg1 zuzuordnen sind. Da entsprechend Fig. 4 der Ansteuerimpuls der zweiten Strahlungsquelle q2 kurz hinter dem Ansteuerimpuls der ersten Strahlungsquelle q1 erfolgt, kann die eindeutige Zuordnung dadurch bestimmt werden, daß mit abnehmender Taktflanke der Detektor-Ausgangssignale p1, p2 ein Zeitfenster zt ausgelöst wird. Dieses überdeckt das Ansteuerintervall t2 für die zweite Strahlungsquelle q2. Bei der Auslösung durch die zweite Strahlungsquelle q2 liegt das Zeitfenster zt' aber innerhalb des Pausenintervalls pv. Durch einfache logische Vernüpfung läßt sich somit erreichen, daß die empfangenen Detektor-Ausgangssignale p1, p2 entweder dem horizontalen oder dem vertikalen Liniengitter lg2, lg1 zugeordnet werden. Eine derartige Zuordnungsschaltung ist beispielsweise in der Steuereinrichtung se dargestellt, die das Ausgangssignal des ODER-Gatters od auf den Takteingang des Zeitgebers z und jeweils auf einen Eingang einer ersten und einer zweiten UND-Schaltung u1, u2 schaltet, deren jeweiliger anderer Eingang entweder am Q- bzw. am $\overline{Q}$-Ausgang des Zeitgebers z, z.B. ein Monoflop, liegt. Ist dem Zeitintervall t1 beispielsweise das horizontale Liniengitter lg2 zugeordnet, dann erzeugt die erste UND-Schaltung u1 den zugehörigen Steuerimpuls. Entsprechend wird im Zeitintervall t2 der zugehörige Steuerimpuls durch das zweite UND-Gatter ausgelöst. Die-Ausgangssignale dieser Gatter steuern jeweils zwei Zwischenspeicher r1, ... r4 an, die zu dem jeweiligen Steuerzeitpunkt die beiden digitalen Signale p1', p2' übernehmen. Die vier gespeicherten Werte y1, y2, x1, x2 sind mittels des Multiplexers mx auf einen gemeinsamen Datenbus db geschaltet, der beispielsweise mit dem Dateneingang des Mikroprozessors c gekoppelt ist, indem die eigentliche Amplitudenauswertung erfolgt.

In Fig. 4 ist schematisch der Zeitverlauf einiger Signale der Schaltungsanordnung nach Fig. 3 dargestellt. Die ersten beiden Diagramme zeigen die Ansteuerung der beiden Strahlungsquellen q1, q2, wobei zum Zeitpunkt t1 das horizontale bzw. zum Zeitpunkt t2 das vertikale Liniengitter lg2, lg1 beleuchtet wird. Das dritte bzw. das vierte Diagramm zeigt das Detektor-Ausgangssignal p1, p2 des ersten bzw. des zweiten Strahlungsdetektors sd1, sd2. Dabei ist wie im Realfall angenommen, daß die Horizontal- und Vertikal-Detektorsignale y1, y2, x1, x2 unterschiedliche Signalhöhen aufweisen und durch Störsignale überlagert sind.

Schließlich ist in Fig. 4 als vorletztes Diagramm das Q-Ausgangssignal zq des Zeitgebers z mit dem Zeitfenster zt dargestellt, das durch die Detektor-Ausgangssignale p1, p2 im Zeitintervall t1 ausgelöst wird. Das gestrichelt gezeigte $\overline{Q}$-Ausgangssignal zq' des Zeitgebers z zeigt das Zeitfenster zt', wenn es im zweiten Zeitintervall t2 ausgelöst wird. Durch die dargestellte logische Verknüpfung der beiden UND-Gatter u1, u2 mit dem Zeitgeber z ergibt sich aber auch in diesem Fall eine richtige Zuordnung der horizontalen und der vertikalen Detektorsignale y1, y2, x1, x2. Dabei ist in Fig. 3 angenommen, daß die dargestellten Logikbausteine durch tiefe Steuerpegel aktiviert werden, also eine "negative Logik" vorliegt.

**Patentansprüche**

1. Drahtloses Fernsteuersystem elektronischer Geräte

   - mit einem Fernsteuergeber (f) und einem im elektronischen Gerät (g) angeordneten Fernsteuerempfänger, die durch ein elektrooptisches Übertragungssystem miteinander verbunden sind, das eine Strahlungsquelle (q1, q2) und mindestens zwei Strahlungsdetektoren (sd1, sd2) aufweist, sowie

   - mit den Strahlungsdetektoren (sd1, sd2) zugeordneten Mitteln zur Erzeugung von elektrischen Signalen (x, y) aus der Relativbewegung zwischen Fernsteuergeber (f) und Fernsteuerempfänger bzw. elektronischen Gerät (g), gekennzeichnet durch folgende Merkmale:

   - die Strahlungsquelle befindet sich im Fernbedienungsgeber (f) und ist durch eine erste und eine zweite Strahlungsquelle (q1, q2) gebildet, wobei die Strahlungsrichtungen der beiden Strahlungsquellen zu einander parallel sind,

   - der ersten Strahlungsquelle (q1) ist ein erstes Liniengitter (lg1) zugeordnet,

   - der zweiten Strahlungsquelle (q2) ist ein zweites Liniengitter (lg2) zugeordnet, dessen Gitterebene in der gleichen Gitterebene wie das erste Liniengitter (lg1) liegt, wobei die beiden Gitterausrichtungen zueinander senkrecht verlaufen,

   - der erste und zweite Strahlungsdetektor (sd1, sd2) sind im Fernsteuerempfänger auf einer Verbindungslinie angeordnet, die unter 45° gegenüber den projizierten Bildern (Schatten) der Gittenlinien des ersten und zweiten Liniengitters (lg1, lg2) verläuft,

   - die erste und zweite Strahlungsquelle (q1, q2) sind abwechselnd angesteuert und

   - dem Ansteuersignal der jeweiligen Strahlungsquelle (q1, q2) ist ein Kennsignal aufmoduliert.

**2.** Drahtloses Fernsteuersystem nach Anspruch 1, gekennzeichnet durch folgende Merkmale:
- die erste und zweite Strahlungsquelle (q1, q2) sind mit der gleichen Traktrate angesteuert, wobei die Ansteuerung der zweiten Strahlungsquelle (q2) gegenüber der ersten Strahlungsquelle (q1) um ein festes Intervall zeitlich versetzt ist, so daß der erste und zweite Strahlungsdetektor (sd1, sd2) jeweils eine Doppelimpulsfolge mit ungleichen Pausen- und/oder Impulsintervallen empfängt, und
- eine Steuereinrichtung (se) ordnet mittels mindestens zwei Zeitfenstern (zt, zt') den Amplitudenwert des ersten bzw. zweiten Teils des Doppelimpulses der ersten bzw. zweiten Strahlungsquelle (q1, q2) zu und speichert in jeder Taktperiode diese vier Werte (x1, x2, y1, y2) für eine nachfolgende Amplitudenauswertung und Positionsbestimmung in einer Auswerteschaltung (c) ab.

**3.** Drahtloses Fernsteuersystem nach Anspruch 1 oder 2, dadurch gekennzeichnet, daß die elektronischen Geräte Geräte der Unterhaltungselektronik sind.

**4.** Drahtloses Fernsteuersystem nach einem der Ansprüche 1 bis 3, dadurch gekennzeichnet, daß mittels der Relativbewegung des Fernsteuergebers (f) analoge oder kontinuierliche Steuersignale übertragen werden.

**5.** Drahtloses Fernsteuersystem nach einem der Ansprüche 1 bis 3, dadurch gekennzeichnet, daß mittels der Relativbewegung des Fernsteuergebers (f) Steuersignale für eine Menü-Steuerung übertragen werden.

**Claims**

**1.** A wireless remote-control system for electronic apparatus, comprising
- a remote-control transmitter (f) and a remote-control receiver contained in the electronic apparatus (g) which are interconnected by an electrooptical transmission system comprising a radiation source (q1, q2) and at least two radiation detectors (sd1, sd2), and
- means associated with the radiation detectors (sd1, sd2) for generating electric signals (x, y) from the relative movement of the remote-control transmitter (f) and the remote-control receiver or the electronic apparatus (g),
characterized by the following features:
- The radiation source is located within the remote-control transmitter (f) and is formed by a first radiation source (q1) and a second radiation source (q2) whose directions of radiation are parallel to each other;
- the first radiation source (q1) has a first grating (lg1) associated therewith;
- the second radiation source (q2) has associated therewith a second grating (lg2) whose grating plane lies in the same grating plane as the first grating (lg1), with the two gratings oriented perpendicular to each other;
- the first and second radiation detectors (sd1, sd2) are located within the remote-control receiver on a connecting line which makes angles of 45° with the projected images (shadows) of the lines of the first and second gratings (lg1, lg2);
- the first and second radiation sources (q1, q2) are energized alternately, and
- an identification signal is modulated on the drive signal for the respective radiation source (q1, q2).

**2.** A wireless remote-control system as claimed in claim 1, characterized by the following features:
- The first and second radiation sources (q1, q2) are energized at the same clock rate, with the energization of the second radiation source (q2) shifted in time by a fixed interval with respect to the first radiation source (q1), so that the first and second radiation detectors (sd1, sd2) each receive a double-pulse sequence with unequal spacing and/or pulse intervals, and
- a controller (se) assigns the amplitude values of the first and second parts of the double pulse to the first and second radiation sources (q1, q2), respectively, by means of at least two time windows (zt, zt') and stores these four values (x1, x2, y1, y2) in each clock period in an evaluating circuit (c) for subsequent amplitude evaluation and position determination.

**3.** A wireless remote-control system as claimed in claim 1 or 2, characterized in that the electronic apparatus is entertainment-electronics apparatus.

**4.** A wireless remote-control system as claimed in any one of claims 1 to 3, characterized in that by means of the relative movement of the remote-control transmitter (f), analog or continuous control signals are transmitted.

5. A wireless remote-control system as claimed in any one of claims 1 to 3, characterized in that by means of the relative movement of the remote-control transmitter (f), control signals for a menu control are transmitted.

**Revendications**

1. Système de télécommande sans fil pour appareils électroniques, comportant :
   - un émetteur de télécommande (f) et un récepteur de télécommande disposé dans l'appareil électronique (g), cet émetteur et ce récepteur étant reliés entre eux par un système de transmission électro-optique, qui possède une source de rayonnement (q1, q2) et au moins deux détecteurs de rayonnement (sd1, sd2), et
   - des moyens associés aux détecteurs de rayonnement (sd1, sd2) pour produire des signaux électriques (x, y) à partir du déplacement relatif entre l'émetteur de télécommande (f) et le récepteur de télécommande ou un appareil électronique (g),

   caractérisé par les caractéristiques suivantes :
   - la source de rayonnement est située dans l'émetteur de télécommande (f) et est formée par des première et seconde sources de rayonnement (q1, q2), les directions de rayonnement des deux sources de rayonnement étant parallèles entre elles,
   - un premier réseau de traits (lg1) est associé à la première source de rayonnement (q1),
   - un second réseau de traits (lg2), dont le plan du réseau est situé dans le même plan que le premier réseau de traits (lg1), est associé à la seconde source de rayonnement (q2), les deux orientations des réseaux étant perpendiculaires entre elles,
   - les premier et second détecteurs de rayonnement (sd1, sd2) sont disposés dans le récepteur de télécommande sur une droite qui fait un angle de 45° par rapport aux images projetées (ombres) des traits des premier et second réseaux de traits (lg1, lg2),
   - les première et seconde sources de rayonnement (q1, q2) sont commandées en alternance,
   - le signal de commande de la source respective de rayonnement (q1, q2) est modulé par un signal caractéristique.

2. Système télécommande sans filtre selon la revendication 1, caractérisé par les caractéristiques suivantes :
   - les première et seconde sources de rayonnement (q1, q2) sont commandées par les mêmes cadences, la commande de la seconde source de rayonnement (q2) étant décalée dans le temps d'un intervalle fixe par rapport à la première source de rayonnement (q) de sorte que les premier et second détecteurs de rayonnement (sd2, sd2) reçoivent des suites respectives d'impulsions doubles comportant des intervalles de pause et/ou des intervalles entre impulsions, différents, et
   - un dispositif de commande (se) associe, au moyen de deux créneaux temporels (zt, zt'), la valeur d'amplitude des première et seconde parties de l'impulsion double respectivement aux première et seconde sources de rayonnement (q1, q2) et mémorise, pendant chaque période de cadence, ces quatre valeurs (x1, x2, y1, y2) pour une évaluation ultérieure de l'amplitude et une détermination ultérieure de position dans un circuit d'évaluation (c).

3. Système de télécommande sans fil selon la revendication 1 ou 2, caractérisé en ce que les appareils électroniques sont des appareils de l'électronique du spectacle.

4. Système de télécommande sans fil selon l'une des revendications 1 à 3, caractérisé en ce que des signaux de commande sont transmis de façon analogique ou continue au moyen du déplacement relatif de l'émetteur de télécommande (f).

5. Système de télécommande sans fil selon l'une des revendications 1 à 3, caractérisé en ce que des signaux de commande pour exécuter une commande au moyen d'un menu sont transmis au moyen du déplacement relatif de l'émetteur de télécommande (f).

**FIG.1**

**FIG.2**

FIG. 3

sd1 p1 w1 p1'
A/D

sd2 p2 w2 p2'
A/D

se
od
z
$\bar{q}$  q
u1
u2

r1  r2  r3  r4
x1  x2  y1  y2

mx

db

$\mu P$  c

FIG. 4

t1  t2  pv  t1  t2

q1 ⟶ t

q2 ⟶ t

p1  x1  y1  x1  y1 ⟶ t

p2  x2  y2  x2  y2 ⟶ t

zq  zt ⟶ t

zq'  zt' ⟶ t